# EUROPEAN PATENT APPLICATION

(11) **EP 4 386 814 A1**
(43) Date of publication of application: **19.06.2024**
(21) Application number: 23847861.4
(22) Date of filing: 19.06.2023
(51) Int. Cl.: H01L 21/28, H01L 21/02

(54) **METHOD FOR FORMING IMPROVED INTERFACE AND THIN FILM BY USING HIGH-DENSITY RADICALS**

(30) Priority: 03.11.2022 KR 20220144905
(71) Applicant: EQ Tech Plus Co., Ltd., Suwon-si, Gyeonggi-do 16648 (KR)
(72) Inventor: SHIN, Dong Hwa, Suwon-si, Gyeonggi-do 16648 (KR); KIM, Yong Weon, Suwon-si, Gyeonggi-do 16648 (KR)
(74) Representative: Manitz Finsterwald Patent- und Rechtsanwaltspartnerschaft mbB
(86) International application number: PCT/KR2023/008427
(87) International publication number: WO 2024/096231

(57) **Abstract**

According to one embodiment, a method of forming an oxide film by using a deposition apparatus includes depositing an insulating film on a silicon substrate, and forming an SiO₂ thin film between the silicon substrate and the insulating film by performing annealing using OH radicals on the insulating film by using the deposition apparatus.

## Description

### BACKGROUND

The present disclosure relates to a method of improving properties of interfaces and thin films by using high-density radicals.

As technology advances, semiconductor devices, which are the foundation of core technologies of the fourth industrial revolution such as artificial intelligence, big data, five generation (5G), and self-driving cars, require multi-layer structures and complex circuit patterns to increase the speed of non-memory devices (system LSI) and the capacity of memory devices (DRAM, 3D_VNAND).

Accordingly, semiconductor patterning technology with a line width of 5 nm or less is currently secured through the introduction of extreme ultraviolet (EUV), and so on, but there is a need to solve problems such as non-uniformity of thin film thickness, poor deposition of high aspect ratio contact holes, and low step coverage, which are the limitations of existing thin film deposition technology.

Also, when manufacturing semiconductor devices, the defect density is high at an interface between a base film and a deposited film, which reduces electrical properties and causes a decrease in device yield.

In addition, there is a problem that impurities are generated inside a film during a deposition process, and a subsequent heat treatment process for densifying the film has to be further introduced to remove the impurities.

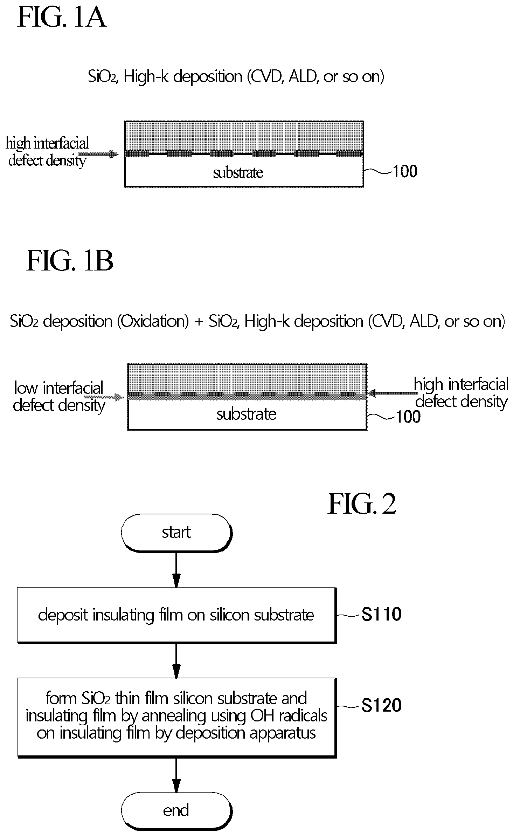

FIG. 1 is an example view illustrating a process of improving the properties of a conventional interface and thin film.

First, in the first embodiment, as illustrated in FIG. 1A, SiO₂ or High-k is deposited on a substrate 100 through a technology such as chemical vapor deposition (CVD) or atomic layer deposition (ALD). However, in the conventional technology, an interface between the substrate 100 and a deposition surface has a high interfacial defect density. In this case, only physical bonding exists between the substrate 100 and an insulating film, and thus, a significant amount of defects occurs between the substrate 100 and the insulating film. That is, the substrate 100 and the insulating film are not strongly bonded together.

In order to solve the problems of the first embodiment described above, in a second embodiment, SiO₂ is first oxidized thinly on a substrate as illustrated in FIG. 1B, and additionally SiO₂ or High-k is deposited through a technology such as CVD or ALD. In this case, the first deposition of SiO₂ is performed through oxidation, and accordingly, the substrate 100 has a low interface defect density. Accordingly, a bonding strength between the substrate 100 and the insulating film is increased, but the second embodiment also has a limitation in that physical defects occurring between SiO₂ and the insulating film also exist.

### SUMMARY

The present disclosure is intended to solve the problems of the related art described above, and a purpose of the present disclosure is to permeate reaction gas into an interface during subsequent heat treatment by using high-density radicals in order to solve the problem of defects caused by surface reaction and uneven diffusion of a film due to low reaction energy when applying post deposition anneal (PDA) technique, according to an embodiment of the present disclosure.

Also, another purpose of the present disclosure is to form a film with low defect density and high density by inducing permeation and substitution reactions with high-density radical, removing impurities in a film, and performing homogeneous chemical bonding with the interface.
according to an aspect of the present disclosure, a method of forming an oxide film by using a deposition apparatus includes depositing an insulating film on a silicon substrate, and forming an SiO₂ thin film between the silicon substrate and the insulating film by performing annealing using OH radicals on the insulating film by using the deposition apparatus.

Also, in the depositing of the insulating film, the insulating film may be deposited based on any one of chemical vapor deposition (CVD) and atomic layer deposition (ALD).

Also, the insulating film may be composed of any one of a silicon oxide film and a high-k film.

Also, in the forming of the SiO₂ thin film, the SiO₂ thin film may be formed as the OH radicals permeate into the insulating film and reacts with silicon included in the silicon substrate.

Also, in the forming of the SiO₂ thin film, a thickness of the SiO₂ thin film between the silicon substrate and the insulating film may be adjusted by adjusting annealing time.

Also, a process of spraying the OH radicals in the forming of the SiO₂ thin film may be performed at a process temperature of between 480 degrees and 730 degrees.

Also, the depositing of the insulating film and the forming of the SiO₂ thin film may be included in a process of forming a gate oxide film among processes of forming a semiconductor device.

The present disclosure is intended to solve the problems of the related art described above, and the present disclosure may permeate reaction gas into an interface during subsequent heat treatment by using high-density radicals in order to solve the problem of defects caused by surface reaction and uneven diffusion of a film due to low reaction energy when applying post deposition anneal (PDA) technique, according to an embodiment of the present disclosure.

Also, a film with low defect density and high density may be formed by inducing permeation and substitution reactions with high-density radical, removing impurities in a film, and performing homogeneous chemical bonding with the interface.

### BRIEF DESCRIPTION OF THE DRAWINGS

Embodiments of the inventive concept will be more clearly understood from the following detailed description taken in conjunction with the accompanying drawings in which:
FIGS. 1A and 1B are example views illustrating a process of improving properties of a conventional interface and thin film;
FIG. 2 is an operational flowchart of a deposition process in which the properties of an interface and a thin film are improved by using high-density radicals, according to an embodiment of the present disclosure;
FIG. 3 illustrates a deposition process in which the properties of an interface and a thin film are improved by using high-density radicals, according to an embodiment of the present disclosure;
FIG. 4A illustrates thicknesses of deposition surfaces during annealing by using high-density radicals and different gas, according to an embodiment of the present disclosure; and
FIG. 4B illustrates thicknesses of deposition surfaces according to annealing time, according to an embodiment of the present disclosure.

### DETAILED DESCRIPTION OF THE EMBODIMENTS

Hereinafter, embodiments of the present disclosure will be described in detail with reference to the accompanying drawings such that those skilled in the art in which the present disclosure belongs may easily practice the present disclosure. However, the present disclosure may be implemented in many different forms and is not limited to the embodiments described herein. In addition, in order to clearly describe the present disclosure, parts irrelevant to the description are omitted in the drawings, and similar reference numerals are attached to similar parts throughout the specification.

When it is described that a portion is "connected" to another portion throughout the specification, this includes not only a case where the portion is "directly connected" to another portion but also a case where the portion is "electrically connected" to another portion with another component therebetween. In addition, when it is described that a portion "includes" a certain component, this means that the portion may further include another component without excluding another component unless otherwise stated.

The following embodiments are detailed descriptions to aid understanding of the present disclosure and do not limit the scope of the present disclosure. Accordingly, inventions of the same scope and performing the same function as the present disclosure will also fall within the scope of rights of the present disclosure.

A thin film or deposition, which is defined in the specification of the present disclosure below, may refer to a process of thinly coating a surface of a wafer (substrate) with an oxide or metal by alternately adsorbing and replacing molecules on the surface of the wafer in a semiconductor manufacturing process. Accordingly, each process described in the following specification may be performed by a radical unit, a deposition apparatus, or so on, and thin film deposition may be performed by a technology such as atomic layer deposition (ALD), chemical vapor deposition (CVD), or so on.

FIG. 2 is an operational flowchart of a deposition process in which the properties of an interface and a thin film are improved using high-density radicals, according to an embodiment of the present disclosure.

In this case, step S110 and step S120 to be described below may be included in a process of forming a gate oxide film during a process of forming a semiconductor device.

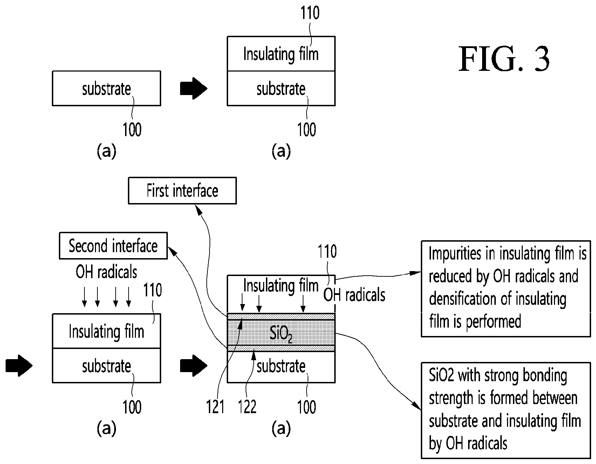

Referring to FIG. 2, a deposition apparatus may deposit an insulating film 110 (see FIG. 3) on a silicon substrate 100 (see FIG. 3) (S110).

In the process of step S110, as illustrated in (a) and (b) of FIG. 3, when the insulating film 110 is deposited on the substrate 100 formed of silicon, the insulating film 110 may be deposited by using any one technology among CVD and ALD.

Also, the insulating film 110 formed through step S110 may be composed of either a silicon oxide film or a high-k film.

Next, an SiO₂ thin film 120 may be formed between the silicon substrate 100 and the insulating film 110 by performing annealing using OH radicals on the insulating film 110 by a deposition apparatus (S120).

In step S120, the annealing using OH radicals may be performed by spraying OH radicals on the insulating film 110, as illustrated in (c) and (d) of FIG. 3. In this case, the OH radicals permeate into the insulating film 110 and react with the silicon included in the silicon substrate 100, and thereby, the SiO₂ thin film 120 may be formed at an interface as illustrated in (d) of FIG. 3.

As the OH radicals permeate into the insulating film 110 and oxidize a portion between the insulating film 110 and the silicon substrate 100, an SiOₓ (SiO or SiO₂) film may be formed at an interface between the insulating film 110 and the silicon substrate 100.

In this case, both a first interface 121 between the SiO₂ thin film 120 and the insulating film 110, and a second interface 122 between the silicon substrate 100 and the SiO2 thin film 120 have low interfacial bonding density (chemical bonding), and accordingly, impurities in a film are reduced, and high binding strength is achieved.

The known annealing process aims to improve interface properties of the upper surface of the insulating film 110, and various gases such as N₂, H₂, and O₂ are used in the known annealing process. The known process has a limitation in that gas such as N₂ may not permeate deeply into the insulating film 110.

However, the purpose of an annealing process performed in step S120 is to deeply permeate OH radicals into the insulating film 110. Accordingly, the OH radicals permeated into the insulating film 110 by the process proposed in the present disclosure form the oxide thin film 120 between the silicon substrate 100 and the insulating film 110, and thereby, the silicon substrate 100 and the insulating film 110 may be strongly bonded together. That is, impurities in the insulating film 110 may be reduced by OH radicals, densification of the insulating film 110 may be performed, and an SiO₂ thin film may be formed to strongly bond the substrate 100 and the insulating film 110 together.

Also, there is a difference between the known technology and the present process in that the SiO₂ thin film formed by the process of step S110 to step S120 is not formed sequentially but is formed in a reverse sequence after the insulating film 110 is formed.

Also, the thin film generally first formed on the substrate is preferably a high-k film (for example, Al₂O₃ or so on, but includes various other high-k materials), but in some cases, the thin film may be composed of SiO₂. In this case, in the process presented in the present disclosure, the SiO₂ thin film 120 has to be deposited by CVD or ALD, and the SiO₂ thin film 120 formed through thermal oxidation is not included in the technology proposed by the present disclosure. This is because an interfacial layer formed at an interface through the technology proposed by the present disclosure reacts with the silicon substrate 100 to form SiO₂ thin film.

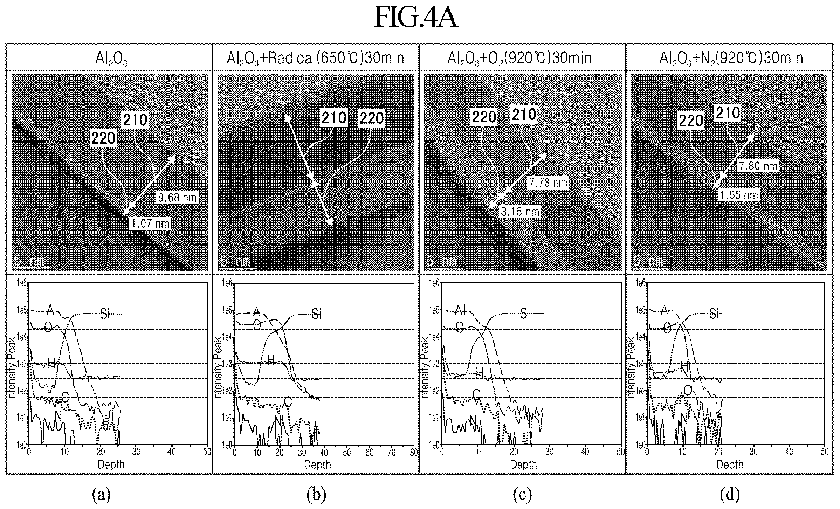

FIG. 4A illustrates a result of comparing thicknesses of insulating films formed when annealing is performed by the high-k process of the present disclosure and the known process.

(a) of FIG. 4A may be an example of a cross-section when only a high-k insulating film is deposited. In this case, it can be seen that an Al₂O₃ layer (210), which is a high-k layer, is formed to have a predetermined thickness and an SiO₂ layer 220 is formed to have a thin thickness between a substrate and the high-k layer.

(b) of FIG. 4A may be an optimal embodiment formed by applying the technology of the present disclosure. That is, this is an embodiment in which a high-k component forms a thin film by using Al₂O₃ and OH radicals.

In the cross-section formed when performing step S110 and step S120 described above, the SiO₂ layer 220 having a predetermined thickness may be formed under the High-k layer. In graphs below the cross-sectional views of thin films, show concentrations of respective components according to depths of the thin films, where the y axis represents the concentration and the x axis represents a depth of the thin film. it can be seen that the N concentration is always uniform according to the change in depth in (b) of FIG. 4A unlike other graphs. Also, it can be seen that a thickness of the SiO₂ layer 220 formed through the process proposed by the present disclosure is the greatest.

(c) of FIG. 4A is an example of a cross-section of a deposition surface when annealing is performed with O₂ gas after the High-k layer is deposited, and (d) of FIG. 4A is an example of a cross-section of a deposition surface when annealing is performed with N₂ gas after the High-k layer is deposited.

In this case, in (c) and (d) of FIG. 4A, annealing is performed at a high temperature of 920°C, and it can be seen that, compared to (a) and (b) of FIG. 4A, a thickness of the high-k layer (Al₂O₃ layer 210) is reduced. That is, the known process illustrated in (c) and (d) of FIG. 4A has a problem in that the High-k layer (Al₂O₃ layer 210) is less than the initially deposited thickness after the process is performed. Accordingly, the SiO₂ layer 220 is deposited to have a predetermined thickness without reducing the thickness of the High-k layer (Al₂O₃ layer 210) formed through the process proposed by the present disclosure, and thus, the interface defect density may be reduced, and technical superior is confirmed.

Meanwhile, in the process proposed by the present disclosure, the thickness of the SiO₂ thin film 120 between the silicon substrate 100 and the insulating film 110 may be adjusted by adjusting the annealing temperature and time, and the process in which OH radicals are sprayed may be performed at a process temperature between 480°C and 730°C.

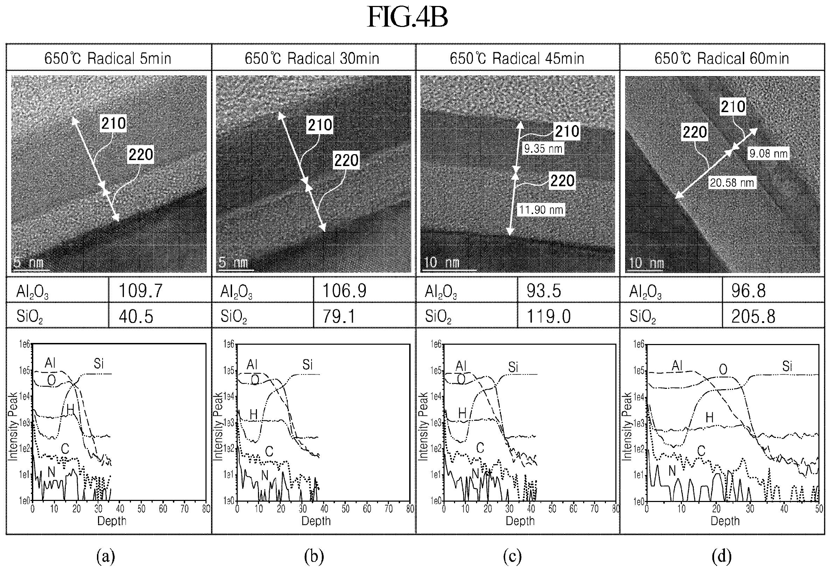

For example, (a) to (d) of FIG. 4B illustrate thicknesses of a deposition surface formed by annealing for OH radicals respectively for 5 minutes, 30 minutes, 45 minutes, and 60 minutes.

In this case, referring to (a) of FIG. 4B, where annealing was performed for 5 minutes, it can be seen that an Al₂O₃ layer 210 and an SiO₂ layer 220 corresponding to High-k respectively have a thickness of 109.7Å and a thickness of 40.5Å, and it can be seen from (b) of FIG. 4B that the Al₂O₃ layer 210 and SiO₂ layer 220 respectively have a thickness of 106.9 Å and a thickness of 79.1 Å. In addition, it can be seen from (c) and (d) of FIG. 4B that the Al₂O₃ layer 210 and the SiO₂ layer 220 respectively have thicknesses of 93.5 Å and 96.8 Å, and thicknesses of 119.0 Å and 205.8 Å Therefore, it can be seen that the thickness of the SiO₂ layer 220 increases while minimizing the change in thickness of the Al₂O₃ layer 210 as the annealing time increases, and a user may select the annealing time suitable for the desired thickness of the SiO₂ layer 220 and perform a thin film formation process.

The above description of the present disclosure is for illustrative purposes, and those skilled in the art to which the present disclosure belongs will understand that the present disclosure may be easily modified into another specific form without changing the technical idea or essential features of the present disclosure. Therefore, the embodiments described above should be understood as illustrative in all respects and not limiting. For example, each component described as a single type may be implemented in a distributed manner, and likewise, components described as distributed may be implemented in a combined form.

The scope of the present disclosure is indicated by the following claims rather than the detailed description above, and the meaning and scope of the claims and all changes or modifications derived from the equivalent concepts should be interpreted as being included in the scope of the present disclosure.

## Claims

1. A method of forming an oxide film by using a deposition apparatus, the method comprising:
depositing an insulating film on a silicon substrate; and
forming an SiO₂ thin film between the silicon substrate and the insulating film by performing annealing using OH radicals on the insulating film by using the deposition apparatus.

2. The method of claim 1, wherein,
in the depositing of the insulating film, the insulating film is deposited based on any one of chemical vapor deposition (CVD) and atomic layer deposition (ALD).

3. The method of claim 1, wherein
the insulating film is composed of any one of a silicon oxide film and a high-k film.

4. The method of claim 1, wherein,
in the forming of the SiO₂ thin film, the SiO₂ thin film is formed as the OH radicals permeate into the insulating film and reacts with silicon included in the silicon substrate.

5. The method of claim 1, wherein,
in the forming of the SiO₂ thin film, a thickness of the SiO₂ thin film between the silicon substrate and the insulating film is adjusted by adjusting annealing time.

6. The method of claim 1, wherein
a process of spraying the OH radicals in the forming of the SiO₂ thin film is performed at a process temperature of between 480 degrees and 730 degrees.

7. The method of claim 1, wherein
the depositing of the insulating film and the forming of the SiO₂ thin film are included in a process of forming a gate oxide film among processes of forming a semiconductor device.
